# EUROPEAN PATENT APPLICATION

(11) **EP 4 686 373 A1**
(43) Date of publication of application: **28.01.2026**
(21) Application number: 24774490.7
(22) Date of filing: 08.02.2024
(51) Int. Cl.: H10N 60/81, F25B 9/00

(54) **BOIL-OFF GAS RE-CONDENSATION DEVICE**

(30) Priority: 22.03.2023 JP 2023045887
(71) Applicant: Sumitomo Heavy Industries, Ltd., Tokyo 141-6025 (JP)
(72) Inventor: MORIE Takaaki, Yokosuka-shi Kanagawa 237-8555 (JP)
(74) Representative: Louis Pöhlau Lohrentz
(86) International application number: PCT/JP2024/004302
(87) International publication number: WO 2024/195344

(57) **Abstract**

Provided is a boil-off gas recondensing device (10) mountable on a boil-off gas exhaust line (130) for releasing an internal pressure of a cryogenic liquid storage tank (112). The boil-off gas recondensing device (10) includes a cryostat (12), and a recondenser (14) that is accommodated in the cryostat (12) and recondenses boil-off gas. The cryostat (12) includes a boil-off gas inflow path (18) that is connected to an introduction path (132) of the boil-off gas exhaust line (130) and allows inflow of the boil-off gas into the recondenser (14) from the introduction path (132), and a boil-off gas outflow path (20) that is connected to an external exhaust path (134) of the boil-off gas exhaust line (130) and allows outflow of the boil-off gas from the recondenser (14) to the external exhaust path (134).

## Description

### Technical Field

The present invention relates to a boil-off gas recondensing device.

### Background Art

In the related art, in a so-called immersion cooling in which a superconducting device is immersed in liquid helium to be cooled, it is known to provide a recondensing device that recondenses vaporized helium gas (also referred to as boil-off gas) as a result of the cooling. The liquid helium obtained by the recondensing can be used to cool the superconducting device again.

### Citation List

### Patent Literature

[PTL 1] Japanese Unexamined Patent Publication No. 2020-92278

### Summary of Invention

### Technical Problem

The above recondensing device is designed to be integrated with the superconducting device as an auxiliary facility, such as being attached as a part of a liquid helium tank. For this reason, in considering a case where the recondensing device is installed afterward into another existing cryogenic system that does not have the recondensing device, it is necessary to perform a significant modification, such as new construction of an attachment interface for the recondensing device in the cryogenic system, which is not easy to achieve.

One exemplary object of an aspect of the present invention is to provide a boil-off gas recondensing device that facilitates post-installation into a cryogenic system.

### Solution to Problem

According to an aspect of the present invention, there is provided a boil-off gas recondensing device mountable on a boil-off gas exhaust line for releasing an internal pressure of a cryogenic liquid storage tank. The boil-off gas exhaust line includes an introduction path for introducing a boil-off gas from the cryogenic liquid storage tank to the boil-off gas recondensing device, and an external exhaust path for exhausting the boil-off gas from the boil-off gas recondensing device to an outside. The boil-off gas recondensing device includes a cryostat, and a recondenser that is accommodated in the cryostat and recondenses the boil-off gas. The cryostat includes a boil-off gas inflow path that is connected to the introduction path of the boil-off gas exhaust line and allows inflow of the boil-off gas into the recondenser from the introduction path, and a boil-off gas outflow path that is connected to the external exhaust path of the boil-off gas exhaust line and allows outflow of the boil-off gas from the recondenser to the external exhaust path.

### Advantageous Effects of Invention

According to the present invention, it is possible to provide the boil-off gas recondensing device that facilitates the post-installation into a cryogenic system.

### Brief Description of Drawings

Fig. 1 is a diagram schematically showing a cryogenic system according to an embodiment.
Fig. 2 is a schematic diagram showing an example of installation of a cryocooler into a cryostat of a boil-off gas recondensing device according to the embodiment.
Fig. 3 is a schematic diagram showing another example of the cryogenic system according to the embodiment.
Fig. 4 is a schematic diagram showing another example of the boil-off gas recondensing device according to the embodiment.

### Description of Embodiments

Hereinafter, embodiments for implementing the present invention will be described in detail with reference to drawings. In the description and drawings, the same reference numerals are assigned to the same or equivalent components, members, and processing, and repeated description is omitted as appropriate. A scale or shape of each part that is shown in the drawings is conveniently set for ease of description and is not interpreted as being limited unless otherwise specified. The embodiments are exemplary, and do not limit the scope of the present invention in any way. All features or combinations thereof described in the embodiments are not necessarily essential to the invention.

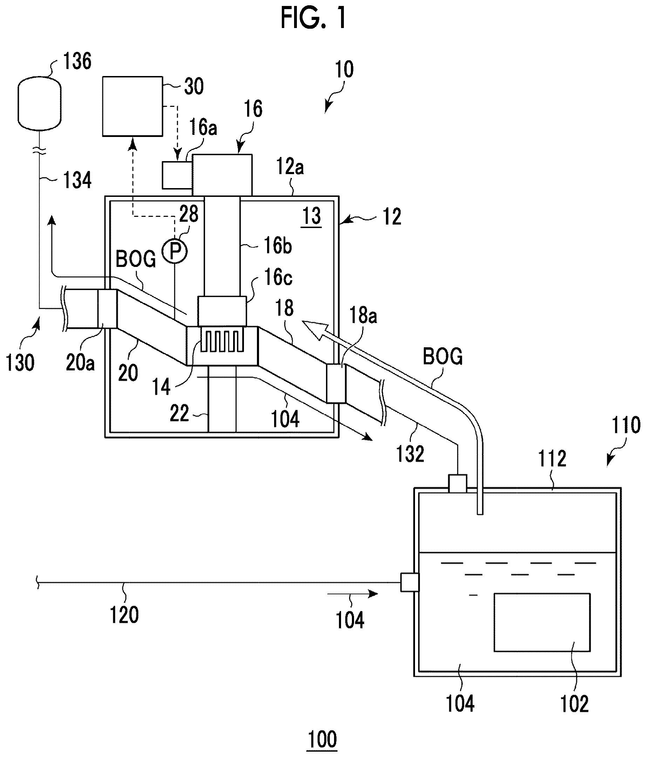

Fig. 1 is a diagram schematically showing a cryogenic system 100 according to the embodiment. The cryogenic system 100 includes a cryogenic cooling device 110 that cools an object to be cooled 102 to a cryogenic temperature. The cryogenic cooling device 110 includes a cryogenic liquid storage tank 112 that holds a cryogenic liquid 104, which is a cryogen for cooling the object to be cooled 102, and can provide immersion cooling. That is, the object to be cooled 102 is disposed in the cryogenic liquid storage tank 112 and is immersed in the cryogenic liquid 104 to be cooled to a temperature of the cryogenic liquid 104.

The object to be cooled 102 is, for example, a superconducting apparatus, such as a superconducting motor or a superconducting magnet, equipped with a superconducting coil. Alternatively, the object to be cooled 102 may be other apparatuses for which the cryogenic temperature is desired as an operating environment.

The cryogenic liquid 104 is a refrigerant having a boiling point of 10 K or more in the embodiment, and is, for example, liquid hydrogen. Alternatively, the cryogenic liquid 104 may be liquid neon. The cryogenic liquid 104 may be a refrigerant having a boiling point lower than a boiling point of nitrogen (about 77 K).

Further, the cryogenic system 100 includes a cryogenic liquid supply line 120 and a boil-off gas exhaust line 130, which are connected to the cryogenic liquid storage tank 112. The cryogenic liquid 104 (for example, liquid hydrogen) can be supplied from a cryogenic liquid source (not shown) to the cryogenic liquid storage tank 112 through the cryogenic liquid supply line 120. The cryogenic liquid 104 may be vaporized by the cooling of the object to be cooled 102 or by heat intrusion from the outside of the cryogenic liquid storage tank 112. A boil-off gas (for example, hydrogen gas) BOG that is generated in this manner may increase an internal pressure of the cryogenic liquid storage tank 112. The boil-off gas exhaust line 130 is provided for releasing the internal pressure of the cryogenic liquid storage tank 112. With recovering of the boil-off gas BOG or exhausting of the boil-off gas BOG to an external environment (for example, room temperature atmospheric pressure environment) through the boil-off gas exhaust line 130, it is possible to maintain the internal pressure of the cryogenic liquid storage tank 112 at an appropriate level (for example, positive pressure higher than atmospheric pressure by predetermined pressure).

The boil-off gas exhaust line 130 includes a boil-off gas recondensing device 10, an introduction path 132 for introducing the boil-off gas BOG from the cryogenic liquid storage tank 112 to the boil-off gas recondensing device 10, and an external exhaust path 134 for exhausting the boil-off gas BOG from the boil-off gas recondensing device 10 to the outside.

The boil-off gas recondensing device 10 is a body separated from the cryogenic liquid storage tank 112, and the introduction path 132 connecting the above two devices may be a pipe (for example, flexible pipe or stiff pipe) suitable for transferring a cryogenic medium (that is, boil-off gas). The external exhaust path 134 may also be a pipe suitable for transferring the cryogenic medium. A recovery tank 136 for recovering the exhausted boil-off gas BOG may be connected to the external exhaust path 134.

The boil-off gas recondensing device 10 includes a cryostat 12, a recondenser 14 that is accommodated in the cryostat 12 and recondenses the boil-off gas BOG, and a cryocooler 16 that is mounted on the cryostat 12 to cool the recondenser 14.

The cryostat 12 is a vacuum adiabatic container, and is configured to provide a vacuum environment 13 inside the cryostat 12. The cryostat 12 includes a vacuum wall 12a that separates the vacuum environment 13 from the external environment and surrounds the vacuum environment 13. An adiabatic structure such as a multilayer insulation (MLI) may be provided in a vacuum adiabatic layer inside the vacuum wall 12a in order to enhance adiabaticity.

The cryostat 12 includes a boil-off gas inflow path 18 and a boil-off gas outflow path 20. The boil-off gas inflow path 18 is connected to the introduction path 132 of the boil-off gas exhaust line 130, and allows inflow of the boil-off gas BOG into the recondenser 14 from the introduction path 132. The boil-off gas inflow path 18 may have, in the vacuum wall 12a, a gas inlet 18a serving as an interface of the cryostat 12 to which the introduction path 132 is connected, and the gas inlet 18a may be detachably connected to the introduction path 132.

Further, the boil-off gas outflow path 20 is connected to the external exhaust path 134 of the boil-off gas exhaust line 130, and allows outflow of the boil-off gas BOG from the recondenser 14 to the external exhaust path 134. The boil-off gas outflow path 20 may have, in the vacuum wall 12a, a gas outlet 20a serving as an interface of the cryostat 12 to which the external exhaust path 134 is connected, and the gas outlet 20a may be detachably connected to the external exhaust path 134.

In this manner, a flow path of the boil-off gas separated from the vacuum environment 13 in the cryostat 12 is formed by the boil-off gas inflow path 18, the recondenser 14, and the boil-off gas outflow path 20.

The recondenser 14 is a heat exchanger for recondensing the boil-off gas BOG by heat exchange with the boil-off gas BOG. The recondenser 14 is made of, for example, pure copper (for example, oxygen-free copper, tough pitch copper, or the like), or other high thermal conductivity metal materials. The boil-off gas inflow path 18 and the boil-off gas outflow path 20, which are connected to the recondenser 14, may be made of a metal material (for example, stainless steel) having a lower thermal conductivity than the recondenser 14.

As illustrated, the recondenser 14 may be supported in the cryostat 12 by a support body 22 made of an adiabatic material such as a glass fiber-reinforced resin. Alternatively, the support body 22 may not be provided, and the recondenser 14 may be supported in the cryostat 12 by the cryocooler 16 (in this case, the recondenser 14 may be fixed to a cooling stage 16c described below).

The cryocooler 16 is a single-stage cryocooler, and can provide a cooling temperature of 10 K or more. The cooling temperature provided by the cryocooler 16 is lower than the boiling point of the cryogenic liquid 104 used, and may be lower than the boiling point (about 20 K) of the cryogenic liquid 104, for example, in a case where the liquid hydrogen is used as the cryogenic liquid 104.

The cryocooler 16 includes a drive motor 16a, a cylinder 16b, and a cooling stage 16c. The cryocooler 16 is mounted on the cryostat 12 such that the drive motor 16a is disposed outside the cryostat 12 and the cooling stage 16c is disposed inside the cryostat 12. As illustrated, the cryocooler 16 may be installed on an upper portion of the cryostat 12. The cooling stage 16c is thermally coupled to the recondenser 14 (for example, in contact with an outer surface of the recondenser 14), and the cooling stage 16c cools the recondenser 14.

The cryocooler 16 may be a Gifford-McMahon (GM) cryocooler, as an example. The cylinder 16b connects the drive motor 16a and the cooling stage 16c to each other, and a displacer driven by the drive motor 16a to reciprocate inside the cylinder 16b is provided inside the cylinder 16b. A regenerator is built in the displacer, and an expansion space for working gas, a volume of which changes due to a movement of the displacer, is formed in the cooling stage 16c. In usual, the cooling stage 16c is made of a high thermal conductivity metal material such as pure copper, and the cylinder 16b is made of a metal material (for example, stainless steel) having a lower thermal conductivity than the cooling stage 16c. The cryocooler 16 is configured to cause, in a case where the drive motor 16a is operated, a periodic volume fluctuation in the expansion space and a pressure fluctuation of the working gas in synchronization with the volume fluctuation to be generated to generate a refrigeration cycle. Accordingly, the cryocooler 16 can cool the cooling stage 16c and the recondenser 14 to a desired cooling temperature (for example, temperature of about 10 to 20 K).

The cryocooler 16 is not limited to the GM cryocooler, and may be another type of cryocooler such as a pulse tube cryocooler or a Stirling cryocooler.

In general, in a case where a two-stage cryocooler is installed in a cryostat, a heat shield is required that is attached to a first-stage cooling unit in a manner to surround a second-stage cooling unit to suppress heat intrusion from the outside to the second-stage cooling unit, which may complicate a structure in the cryostat. On the contrary, with the mounting of the single-stage cryocooler 16 on the cryostat 12, it is possible to simplify the structure in the cryostat 12.

The boil-off gas recondensing device 10 can receive the boil-off gas BOG from the cryogenic liquid storage tank 112 to the recondenser 14 through the introduction path 132 and the boil-off gas inflow path 18, recondense a part of the boil-off gas BOG in the recondenser 14, and recover a remaining boil-off gas BOG from the boil-off gas outflow path 20 to the recovery tank 136 through the external exhaust path 134 or release the remaining boil-off gas BOG to the external environment. The boil-off gas BOG liquefied by the recondensing in the recondenser 14, that is, the cryogenic liquid 104 (for example, liquid hydrogen) is returned from the recondenser 14 to the cryogenic liquid storage tank 112 through the boil-off gas inflow path 18 and the introduction path 132.

In order to promote the outflow of the cryogenic liquid 104 from the recondenser 14, the boil-off gas inflow path 18 may be provided at a position lower than the recondenser 14. As illustrated, the boil-off gas inflow path 18 may be inclined downward toward the gas inlet 18a from the recondenser 14. The recondensed boil-off gas BOG can flow downward along the inclination by gravity. Accordingly, it is easy to resupply the cryogenic liquid 104 from the boil-off gas recondensing device 10 to the cryogenic liquid storage tank 112.

Further, in order to avoid the inflow of the recondensed boil-off gas from the recondenser 14 to the boil-off gas outflow path 20, the boil-off gas outflow path 20 may be provided at a position higher than the recondenser 14. As illustrated, the boil-off gas outflow path 20 may be inclined upward toward the gas outlet 20a from the recondenser 14.

According to the embodiment, it is possible to provide the boil-off gas recondensing device that facilitates the post-installation into the cryogenic system 100. With the mounting of the boil-off gas recondensing device 10 on the boil-off gas exhaust line 130 for releasing the internal pressure of the cryogenic liquid storage tank 112, it is possible to cause the boil-off gas recondensing device 10 to be added to the cryogenic cooling device 110 that is not originally provided with the boil-off gas recondensing device 10.

As optional selection, the boil-off gas recondensing device 10 may include a pressure sensor 28 that measures a pressure of the boil-off gas BOG. The pressure sensor 28 may be installed in the recondenser 14, the boil-off gas inflow path 18, or the boil-off gas outflow path 20 to measure the pressure of the boil-off gas BOG.

The pressure sensor 28 and accessory parts thereof, such as electrical wiring, may serve as a heat transfer path from the external environment to the inside of the boil-off gas recondensing device 10. The heat may eventually intrude into the cryogenic liquid storage tank 112 through the above heat transfer path. In order to reduce such a heat intrusion, the pressure sensor 28 may measure the pressure of the boil-off gas BOG at a position as far away as possible from the cryogenic liquid storage tank 112, for example, at the boil-off gas outflow path 20.

Further, the boil-off gas recondensing device 10 may include a controller 30 configured to control a refrigeration output of the cryocooler 16 based on an output of the pressure sensor 28. The controller 30 is connected to the pressure sensor 28 to receive a signal indicating a measured pressure of the boil-off gas BOG, which is measured by the pressure sensor 28. The controller 30 receives the measured pressure signal from the pressure sensor 28, and controls a rotation speed of the drive motor 16a of the cryocooler 16 based on the measured pressure signal. With an increase in the rotation speed of the drive motor 16a, it is possible to increase the refrigeration output of the cryocooler 16, and thus reduce the temperatures of the cooling stage 16c and the recondenser 14 and/or the pressure of the BOG. On the contrary, with a decrease in the rotation speed of the drive motor 16a, it is possible to decrease the refrigeration output of the cryocooler 16, and thus increase the temperatures of the cooling stage 16c and the recondenser 14 and/or the pressure of the BOG.

For example, the controller 30 may compare the measured pressure of the boil-off gas BOG with a first pressure threshold value, increase the refrigeration output of the cryocooler 16 in a case where the measured pressure exceeds the first pressure threshold value, and maintain or decrease the refrigeration output of the cryocooler 16 in a case where the measured pressure falls below the first pressure threshold value. Based on an appropriate pressure range of the cryogenic liquid storage tank 112, the first pressure threshold value can be set as appropriate based on the empirical knowledge of a designer, an experiment or simulation by the designer, or the like. For example, the first pressure threshold value may be an upper limit value of the appropriate pressure range of the cryogenic liquid storage tank 112.

Accordingly, in a case where the pressure of the boil-off gas BOG is high, such as a case where an amount of the cryogenic liquid 104 vaporized in the cryogenic liquid storage tank 112 is large due to the operation of the object to be cooled 102, it is possible to increase recondensing capacity of the recondenser 14, and thus reduce the pressure of the boil-off gas BOG. This is useful for maintaining the internal pressure of the cryogenic liquid storage tank 112 at the appropriate level.

Further, the controller 30 may compare the measured pressure of the boil-off gas BOG with a second pressure threshold value, operate the cryocooler 16 in a case where the measured pressure exceeds the second pressure threshold value, and stop the operation of the cryocooler 16 in a case where the measured pressure falls below the second pressure threshold value. The second pressure threshold value may be a pressure value smaller than the first pressure threshold value. Based on the appropriate pressure range of the cryogenic liquid storage tank 112, the second pressure threshold value can be set as appropriate based on the empirical knowledge of a designer, an experiment or simulation by the designer, or the like. For example, the second pressure threshold value may be a lower limit value of the appropriate pressure range of the cryogenic liquid storage tank 112.

Accordingly, in a case where the amount of the cryogenic liquid 104 vaporized in the cryogenic liquid storage tank 112 is sufficiently small, it is possible to stop the cryocooler 16, and thus turn off the recondensing function of the boil-off gas recondensing device 10. This is useful for improving energy saving performance of the cryogenic system 100.

In an internal configuration of the controller 30, a hardware configuration is formed by an element or a circuit including a CPU or a memory of a computer, and a software configuration is realized by a computer program or the like. However, the internal configuration thereof is shown in the drawing as functional blocks realized in cooperation between the hardware configuration and the software configuration as appropriate. It is understood by those skilled in the art that these functional blocks can be realized in various forms by a combination of hardware and software.

Instead of the pressure sensor 28 or together with the pressure sensor 28, the boil-off gas recondensing device 10 may include a temperature sensor that measures the temperature of the boil-off gas BOG. The temperature sensor may be provided in the recondenser 14 or the cooling stage 16c, and may measure the temperature of the recondenser 14 or the cooling stage 16c.

The controller 30 may be configured to control the refrigeration output of the cryocooler 16 based on an output of the temperature sensor. For example, the controller 30 may compare the measured temperature of the boil-off gas BOG with a first temperature threshold value, increase the refrigeration output of the cryocooler 16 in a case where the measured temperature exceeds the first temperature threshold value, and maintain or decrease the refrigeration output of the cryocooler 16 in a case where the measured temperature falls below the first temperature threshold value. Further, the controller 30 may compare the measured temperature of the boil-off gas BOG with a second temperature threshold value, which is lower than the first temperature threshold value, operate the cryocooler 16 in a case where the measured temperature exceeds the second temperature threshold value, and stop the operation of the cryocooler 16 in a case where the measured temperature falls below the second temperature threshold value.

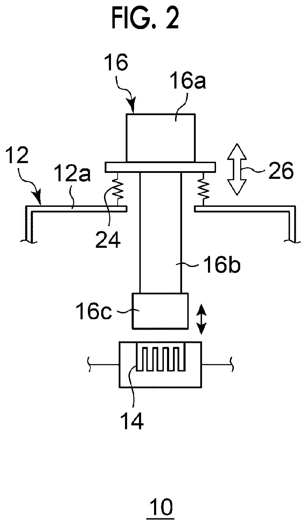

Fig. 2 is a schematic diagram showing an example of installation of the cryocooler 16 into the cryostat 12 of the boil-off gas recondensing device 10, according to the embodiment. The cryocooler 16 may be mounted in the cryostat 12 in a movable manner with respect to the recondenser 14 to be brought into or out of thermal contact with the recondenser 14.

The cryostat 12 may include a bellows 24 that connects the drive motor 16a of the cryocooler 16 to the vacuum wall 12a of the cryostat 12. The bellows 24 connects the cryocooler 16 to the cryostat 12 to maintain airtightness of the vacuum environment 13. The cylinder 16b of the cryocooler 16 extends from the drive motor 16a through an inside of the bellows 24, and the cooling stage 16c is disposed in the cryostat 12.

Further, the cryostat 12 is provided with a movable mechanism 26 disposed outside the cryostat 12. With an operation of the movable mechanism 26, it is possible to cause the bellows 24 to be expanded and contracted and cause the cryocooler 16 to be moved with respect to the cryostat 12. Accordingly, it is possible to cause the cooling stage 16c to be brought into or out of the thermal contact with the recondenser 14. The movable mechanism 26 may have an appropriate drive source such as a hydraulic pressure, an air pressure, an electric motor, or an electromagnet, or may be a movable mechanism driven manually.

The operation of the cryocooler 16 may be stopped as described above by the control of the controller 30. While the operation of the cryocooler 16 is stopped, the cryocooler 16 may be brought out of thermal contact with the recondenser 14 by the operation of the movable mechanism 26. With the above, it is possible to suppress the heat intrusion, to the recondenser 14, from the external environment with the cryocooler 16 that is not in operation as the heat transfer path.

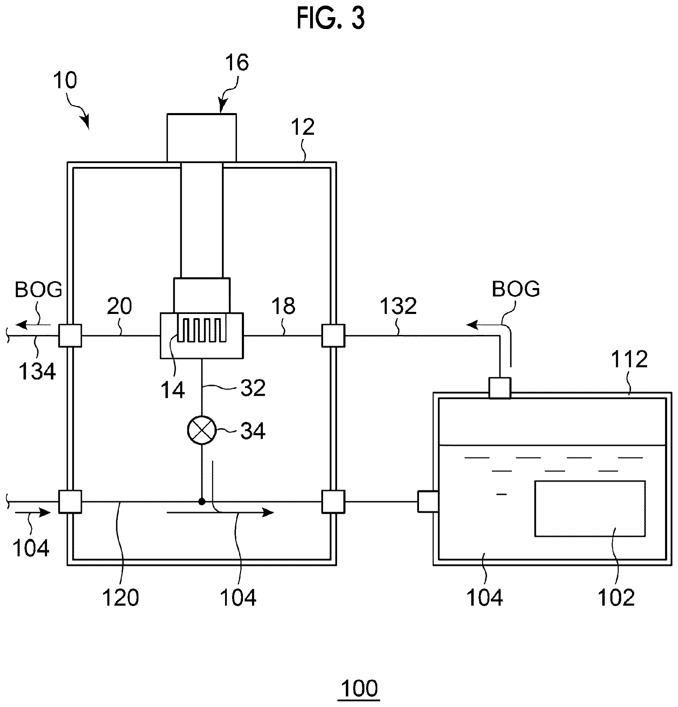

Fig. 3 is a schematic diagram showing another example of the cryogenic system 100 according to the embodiment. In the above embodiment, the cryogenic liquid 104 recondensed in the boil-off gas recondensing device 10 is returned to the cryogenic liquid storage tank 112 through the boil-off gas inflow path 18 and the introduction path 132. However, in the example shown in Fig. 3, a liquid supply path 32 is provided in the boil-off gas recondensing device 10 separately from the boil-off gas inflow path 18.

The liquid supply path 32 is connected to the recondenser 14, and enables the boil-off gas BOG recondensed by the recondenser 14 to be resupplied to the cryogenic liquid storage tank 112. The liquid supply path 32 merges with the cryogenic liquid supply line 120 to the cryogenic liquid storage tank 112. With the above, it is easy to resupply the cryogenic liquid 104 from the boil-off gas recondensing device 10 to the cryogenic liquid storage tank 112.

As illustrated, a portion of the cryogenic liquid supply line 120 may pass through the inside of the cryostat 12, and the recondenser 14 may be disposed above this portion of the cryogenic liquid supply line 120. The recondensed boil-off gas BOG may flow downward the liquid supply path 32 due to gravity from the recondenser 14 to the cryogenic liquid supply line 120.

As optional selection, a valve 34 may be provided in the liquid supply path 32. The valve 34 may be an on/off valve that opens and closes the liquid supply path 32, or a check valve that prevents backflow of the liquid supply path 32.

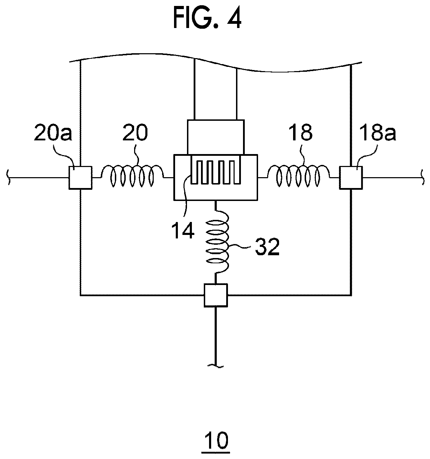

Fig. 4 is a schematic diagram showing another example of the boil-off gas recondensing device 10 according to the embodiment. As illustrated, the boil-off gas inflow path 18 may have a meandering pipe that connects the recondenser 14 to the gas inlet 18a. The meandering pipe may have a two-dimensional meandering shape that meanders along a certain plane. Alternatively, the meandering pipe may have a three-dimensional meandering shape such as a spiral shape. That is, the meandering pipe may include a spiral pipe. With the meandering pipe, it is possible to absorb thermal contraction caused by cryogenic cooling. Similarly, the boil-off gas outflow path 20 and the liquid supply path 32 may also include the meandering pipe.

The present invention has been described above based on the examples. It is understood by those skilled in the art that the present invention is not limited to the above embodiments, various design changes can be made, various modification examples are possible, and such modification examples are also within the scope of the present invention. Various features described in relation to an embodiment are also applicable to other embodiments. A new embodiment resulting from a combination has the effect of each of the embodiments that are combined.

In the above embodiment, a case has been described as an example in which the boil-off gas exhaust line 130 is directly connected to the cryogenic liquid storage tank 112. However, in an embodiment, the boil-off gas exhaust line 130 may be connected to an accessory apparatus provided in the cryogenic liquid storage tank 112. For example, the cryogenic liquid storage tank 112 may be provided with a pressurizing pump that pressurizes and gasifies the cryogenic liquid 104 to generate high-pressure gas, and the boil-off gas exhaust line 130 may be connected to the pressurizing pump. The boil-off gas recondensing device 10 according to the embodiment may be mounted on such a boil-off gas exhaust line 130.

In the above embodiment, a case has been described as an example in which the cryocooler 16 is the single-stage cryocooler. However, in a certain embodiment, the cryocooler 16 may be a two-stage or multi-stage cryocooler. The cryocooler 16 may be any type of cryocooler such as the GM cryocooler, the pulse tube cryocooler, the Stirling cryocooler, or the like.

Although the present invention has been described using specific words and phrases based on the embodiment, the embodiment merely shows one aspect of the principle and application of the present invention, and many modification examples and changes in disposition are allowed without departing from the concept of the present invention specified in the claim.

### Industrial Applicability

The present invention can be used in the field of boil-off gas recondensing device.

### Reference Signs List

- 10: boil-off gas recondensing device
- 12: cryostat
- 14: recondenser
- 16: cryocooler
- 18: boil-off gas inflow path
- 20: boil-off gas outflow path
- 30: controller
- 32: liquid supply path
- 104: cryogenic liquid
- 112: cryogenic liquid storage tank
- 120: cryogenic liquid supply line
- 130: boil-off gas exhaust line
- 132: introduction path
- 134: external exhaust path
- BOG: boil-off gas

## Claims

1. A boil-off gas recondensing device mountable on a boil-off gas exhaust line for releasing an internal pressure of a cryogenic liquid storage tank, in which the boil-off gas exhaust line includes an introduction path for introducing a boil-off gas from the cryogenic liquid storage tank to the boil-off gas recondensing device, and an external exhaust path for exhausting the boil-off gas from the boil-off gas recondensing device to an outside, the boil-off gas recondensing device comprising:
a cryostat; and
a recondenser that is accommodated in the cryostat and recondenses the boil-off gas,
wherein the cryostat includes
a boil-off gas inflow path that is connected to the introduction path of the boil-off gas exhaust line and allows inflow of the boil-off gas into the recondenser from the introduction path, and
a boil-off gas outflow path that is connected to the external exhaust path of the boil-off gas exhaust line and allows outflow of the boil-off gas from the recondenser to the external exhaust path.

2. The boil-off gas recondensing device according to claim 1,
wherein a boiling point of the boil-off gas is 10 K or more.

3. The boil-off gas recondensing device according to claim 1, further comprising:
a single-stage cryocooler mounted on the cryostat to cool the recondenser.

4. The boil-off gas recondensing device according to claim 3, further comprising:
a sensor that measures a pressure or a temperature of the boil-off gas; and
a controller that is configured to control a refrigeration output of the cryocooler based on an output of the sensor.

5. The boil-off gas recondensing device according to claim 4,
wherein the controller is configured to compare the output of the sensor with a first threshold value, increase the refrigeration output of the cryocooler in a case where the output of the sensor exceeds the first threshold value, and maintain or decrease the refrigeration output of the cryocooler in a case where the output of the sensor falls below the first threshold value.

6. The boil-off gas recondensing device according to claim 5,
wherein the controller is configured to compare the output of the sensor with a second threshold value, which is lower than the first threshold value, operate the cryocooler in a case where the output of the sensor exceeds the second threshold value, and stop the operation of the cryocooler in a case where the output of the sensor falls below the second threshold value.

7. The boil-off gas recondensing device according to any one of claims 1 to 6, further comprising:
a liquid supply path that is connected to the recondenser and allows the boil-off gas recondensed by the recondenser to be resupplied to the cryogenic liquid storage tank.

8. The boil-off gas recondensing device according to claim 7,
wherein the liquid supply path merges with a cryogenic liquid supply line to the cryogenic liquid storage tank.
